# EUROPÄISCHE PATENTSCHRIFT

(11) **EP 2 666 023 B1**
(45) Veröffentlichungstag und Bekanntmachung des Hinweises auf die Patenterteilung: **11.03.2015**
(21) Anmeldenummer: 12701468.6
(22) Anmeldetag: 13.01.2012
(51) Int. Cl.: G01R 15/18, G01R 19/20

(54) **STROMMESSVORRICHTUNG**
CURRENT MEASURING DEVICE
APPAREIL DE MESURE DE COURANT

(30) Priorität: 17.01.2011 DE 102011002756
(43) Veröffentlichungstag der Anmeldung: 27.11.2013
(73) Patentinhaber: Sunways AG Photovoltaic Technology, 78467 Konstanz (DE)
(72) Erfinder: DOBRENKO, Alexey, 78464 Konstanz (DE); LARIONOV, Pavel, 78464 Konstanz (DE); HAUSER, Thomas, 78467 Konstanz (DE)
(74) Vertreter: Isarpatent
(86) Internationale Anmeldenummer: PCT/EP2012/050498
(87) Internationale Veröffentlichungsnummer: WO 2012/098054

(56) Entgegenhaltungen:
- EP-A1- 1 505 398
- WO-A1-2010/082115
- GB-A- 1 488 262
- US-A- 1 524 285
- US-A- 4 276 510

## Beschreibung

### GEBIET DER ERFINDUNG

Die Erfindung betrifft eine Strommessvorrichtung zum Erfassen eines durch eine Stromleitung fließenden Stroms. Die Erfindung betrifft ferner einen Solarinverter und ein Verfahren zum Erfassen eines Stroms.

### TECHNISCHER HINTERGRUND

Es existiert eine Vielzahl von Anwendungen, in denen eine sehr genaue Erfassung kleiner Gleichströme (DC) und Wechselströme (AC) erforderlich ist. Insbesondere ist dies bei elektrischen Fehlerstromschutzschaltungen (oder kurz Schutzschaltungen) der Fall, mit denen ein Fehlerstrom oder allgemein ein Differenzialstrom gemessen werden kann. Eine solche Schutzschaltung kann zum Beispiel ein FI-Schutzschalter oder eine Abschaltvorrichtung eines Solarinverters, insbesondere eines transformatorlosen Solarinverters, sein.

Zur Messung eines Stroms in elektrischen Schaltungen sind Stromsensoren vorgesehen. Diese Stromsensoren arbeiten auf der Basis eines offenen Magnetkreises und einem Magnetfeldempfindlichen Sensor, z.B. ein Hall-Sensor, welcher in dem Luftspalt des Magnetkreises platziert wird. Problematisch ist diese Art von Stromsensoren bei durch externe Einflüsse auftretende, magnetische Feldern, welche durch den Luftspalt des Magnetkreises in den Magnetkreis eindringen. In diesen Fällen sind die durch solche Stromsensoren erzeugten Messergebnisse mehr oder weniger stark verfälscht. Diese Stromsensoren sind daher nur bedingt für die Messung kleiner und sehr kleiner Ströme, zum Beispiel von Strömen in einem Bereich von bis zu 50 mA, geeignet.

Speziell für eine Fehlerstromerfassung, bei denen sehr kleine Differenzströme gemessen werden sollen, werden im Allgemeinen auf einem Transformatorprinzip basierende Stromsensoren verwendet. Das magnetische Wechselfeld eines durch einen Differentialstrom durchflossenen Leiter induziert bei diesen Sensoren einen Wechselstrom in einer Spule. Dieser Wechselstrom ist dem zu messenden Strom proportional und kann zum Beispiel über einen Messwiderstand erfasst werden. Diese Sensoren sind schaltungstechnisch sehr einfach aufgebaut und benötigen keine externe Energieversorgung. Allerdings können diese Stromsensoren bedingt durch das Messprinzip nicht dazu ausgelegt, Gleichströme zu messen. Für den Einsatz in elektrischen Schutzschaltungen ist diese Art der Stromsensoren ungeeignet.

Um parallel zu Wechselströmen noch die Gleichströme zu erfassen, werden meist Stromsensoren verwendet, welche auf einem magnetischen Multivibratorverfahren beruhen. Bei diesen Sensoren wird das Pulsweitenverhältnis einer Trägerspannung durch den zu messenden Strom beeinflusst. Diese Sensoren weisen aber eine geringe Empfindlichkeit auf und das Ergebnis der Strommessung wird von der Versorgungsspannung des Stromsensors beeinflusst.

Die heute verfügbaren Gleich- und Wechselstromsensoren, welche auch als Allstromsensoren bezeichnet werden und welche dazu ausgelegt sind, auch sehr kleine Ströme mit einer hinreichend großen Genauigkeit zu messen, sind schaltungstechnisch sehr aufwändig in ihrem Aufbau und folglich sehr kostenintensiv.

Die US 4,276,510 A zeigt einen Stromsensor zur Messung eines Transformatorstroms als Funktion der Kerninduktivität.

Die WO 2010/082115 A1 zeigt ein Verfahren zum Messen eines elektrischen Stroms.

Die EP 1 505 398 A1 offenbart eine Schaltung zur Erfassung eines Gleichstroms.

### ZUSAMMENFASSUNG DER ERFINDUNG

Vor diesem Hintergrund ist es eine Aufgabe der vorliegenden Erfindung, einen einfachen Gleich- und Wechselstromsensor bereitzustellen.

Erfindungsgemäß wird diese Aufgabe durch eine Strommessvorrichtung mit den Merkmalen des Patentanspruchs 1 und/oder durch einen Solarinverter mit den Merkmalen des Patentanspruchs 13 und/oder durch ein Verfahren mit den Merkmalen des Patentanspruchs 14 gelöst.

Demgemäß ist vorgesehen:
- eine Strommessvorrichtung zum Erfassen eines durch eine Stromleitung fließenden Stroms, mit einer Magnetschleife zur Aufnahme der Stromleitung; mit einer Erregervorrichtung, welche dazu ausgebildet ist, die Magnetschleife mittels eines solchen periodischen Signals zu magnetisieren, dass der Erregerstrom immer zwischen zwei Sättigungsgrenzen pendelt; mit einem ersten Stromsensor, welcher dazu ausgebildet ist, einen auf Grund des periodischen Signals und/oder des zu erfassenden Stroms in der Erregervorrichtung fließenden Erregerstrom zu erfassen; mit einer
- Ermittlungsvorrichtung, welche eine durch den Strom hervorgerufene Verschiebung des erfassten Erregerstroms auf der Stromachse ermittelt und daraus die Stromstärke des zu erfassenden Stroms ableitet.
- Ein Solarinverter, insbesondere ein transformatorloser Solarinverter, mit einer erfindungsgemäßen Strommessvorrichtung.
- Ein Verfahren zum Erfassen eines Stroms, insbesondere mittels einer erfindungsgemäßen Strommessvorrichtung, mit den Schritten: Magnetisieren einer Magnetschleife zur Aufnahme einer Stromleitung mittels eines periodischen Signals durch eine Erregervorrichtung; Durchführen einer Stromleitung durch die Magnetschleife; Bestromen der Stromleitung mit dem zu erfassenden Strom; Erfassen eines Erregerstromes, welcher auf Grund des periodischen Signals und/oder auf Grund des Stroms in der Erregervorrichtung fließt; Ableiten einer Stromstärke des zu erfassenden Stroms aus der Verschiebung des erfassten Erregerstroms auf der Stromachse.

Die der vorliegenden Erfindung zugrunde liegende Erkenntnis besteht darin, dass ein durch die Erregervorrichtung fließender Erregerstrom nicht nur von dem periodischen Signal, sondern auch von dem durch die Stromleitung fließenden Strom selbst beeinflusst wird. Die, der vorliegenden Erfindung zugrunde liegende Idee besteht nun darin, dieser Erkenntnis Rechnung zu tragen und eine durch den durch die Stromleitung fließenden Strom hervorgerufene Verschiebung der Sättigungsgrenzen des Erregerstroms auszuwerten und daraus die Stromstärke des durch die Stromleitung fließenden Stroms abzuleiten.

Das periodische Signal prägt in der Erregervorrichtung für den Fall, dass in der Stromleitung kein Strom fließt, einen periodischen Strom ein, welcher einen auf der Stromachse zu Null symmetrischen Verlauf aufweist.

Wird die Stromleitung von einem zu erfassenden Strom durchflossen, wird der Verlauf des periodischen Erregerstroms auf der Stromachse in den positiven oder negativen Bereich verschoben. Die Richtung dieser Verschiebung ist abhängig von dem Vorzeichen des Stroms in der Stromleitung und der Betrag dieser Verschiebung ist proportional zu der Stromstärke des zu erfassenden Stroms in der Stromleitung.

Die vorliegende Strommessvorrichtung erfasst den Verlauf des Erregerstroms in der Erregervorrichtung mittels eines Stromsensors und bestimmt mit Hilfe einer Ermittlungsvorrichtung die Verschiebung des periodischen Verlaufs des Erregerstroms auf der Stromachse gegenüber Null und leitet daraus die Stromstärke des zu erfassenden Stroms ab. Der Stromsensor, welcher den Verlauf des Erregerstroms erfasst, kann in seiner einfachsten Ausführung als einfacher Mess- oder Shuntwiderstand ausgebildet sein. Dadurch ergibt sich ein besonders einfacher Aufbau der Strommessvorrichtung. In weiteren Ausführungsformen kann der Stromsensor auch auf beliebig andere Weise aufgebaut sein.

Mit Hilfe der erfindungsgemäßen Strommessvorrichtung ist es möglich, einen sehr einfachen, jedoch nichts desto trotz sehr präzise arbeitenden Gleich- und Wechselstromsensor bereitzustellen, der durch extern eingekoppelte Magnetfelder nicht oder zumindest in sehr geringem Umfang beeinflussbar ist. Der Gleich- und Wechselstromsensor kann insbesondere in solchen Anwendungen eingesetzt werden, welche eine sehr hohe Genauigkeit erfordern, gleichzeitig aber nicht frei von externen Störfeldern sind.

Vorteilhafte Ausgestaltungen und Weiterbildungen ergeben sich aus den weiteren Unteransprüchen sowie aus der Beschreibung unter Bezugnahme auf die Figuren der Zeichnung.

In einer bevorzugten Ausführungsform weist die Erregervorrichtung einen Erregergenerator auf, welcher als periodisches Signal eine periodische Spannung generiert, so dass der vom Erregergenerator Erregerstrom immer zwischen zwei Sättigungsgrenzen pendelt. Die Erregervorrichtung weist ferner eine Erregerspule auf, welche dazu ausgebildet ist, die Magnetschleife mittels der periodischen Spannung zu magnetisieren. Der Erregergenerator kann als eine Wechselstromquelle ausgebildet sein, welche eine rechteckige, sinusförmige oder eine beliebig anders ausgebildete periodische Spannung erzeugt. In alternativen Ausführungsformen kann der Erregergenerator ein periodisches Signal aber auch über eine Anordnung von Schaltelementen, wie zum Beispiel eine Voll- oder Halbbrücke, erzeugen. Ein solcher Aufbau ermöglicht es, den Verlauf der periodischen Spannung, zum Beispiel in Abhängigkeit von dem Einsatzgebiet der Strommessvorrichtung, zu beeinflussen. Wird eine einzelne Erregerspule verwendet, um die Magnetschleife mittels des periodischen Signals zu magnetisieren, dann ergibt sich vorteilhafterweise ein besonders einfacher Aufbau der Strommessvorrichtung. Wird dagegen statt der einzelnen Erregerspule eine Transformatorvorrichtung verwendet, um die Magnetschleife zu magnetisieren, dann ist eine flexible Anpassung der Erregervorrichtung an die jeweilige Anwendung möglich.

In einer weiteren Ausführungsform weist die Ermittlungsvorrichtung eine Zeitmessvorrichtung auf, welche für jede Periode des periodischen Erregerstroms eine erste Zeitdauer misst, in welcher der erfasste Erregerstrom einen positiven Betrag aufweist. Die Zeitmessvorrichtung misst für jede Periode des periodischen Erregerstroms eine zweite Zeitdauer, in welcher der erfasste Erregerstrom einen negativen Betrag aufweist. Die Ermittlungsvorrichtung weist eine Integrationsvorrichtung auf, welche als Maß für den zu erfassenden Strom eine Differenz zwischen der gemessenen ersten Zeitdauer und der gemessenen zweiten Zeitdauer integriert. Eine solche Ausgestaltung der Ermittlungsvorrichtung ermöglicht einen schaltungstechnisch sehr einfachen Aufbau durch Verwendung von einfachen analogen Komponenten. Wird der erste Stromsensor zum Beispiel als Shuntwiderstand ausgeführt, kann die Zeitmessvorrichtung z.B. als einfacher Komparator ausgeführt werden. Der Komparator gibt ein positives Signal aus, falls über den Shuntwiderstand eine positive Spannung abfällt, und der Komparator gibt ein negatives Signal aus, falls über den Shuntwiderstand eine negative Spannung abfällt. Die Integrationsvorrichtung kann dann als Tiefpass ausgeführt werden, welcher als Eingangssignal das Ausgangssignal des Komparators erhält und welcher ein Ausgangssignal erzeugt, welches ein Maß für den zu erfassenden Strom ist.

In einer weiteren bevorzugten Ausgestaltung weist die Ermittlungsvorrichtung eine Filtervorrichtung auf, welche aus dem erfassten Erregerstrom einen Gleichanteil als Maß für den zu erfassenden Strom heraus filtert. Der Gleichanteil des erfassten Erregerstroms spiegelt die Verschiebung des Verlaufs des Erregerstroms auf der Stromachse wieder. Damit ist das Ausgangssignal des Filters ebenfalls ein Maß für die Stromstärke des zu erfassenden Stroms. Wird eine Filtervorrichtung verwendet, welche den Gleichanteil des Erregerstroms aus dem Erregerstrom filtert, kann vorteilhafterweise auch auf eine Zeitmessvorrichtung und eine Integrationsvorrichtung verzichtet werden. Zudem ist ein besonders einfacher schaltungstechnischer Aufbau der Strommessvorrichtung möglich, da ein solches Filter aus einfachen analogen Bauelementen, wie zum Beispiel Widerständen, Induktivitäten, etc., aufgebaut sein kann.

In einer bevorzugten Weiterbildung ist eine Kompensationsvorrichtung vorgesehen, welche dazu ausgebildet ist, die Magnetschleife zusätzlich in Abhängigkeit von der ermittelten Stromstärke zu magnetisieren. Ohne eine Kompensationsvorrichtung gerät das Material der Magnetschleife ab einer bestimmten Stärke des zu erfassenden Stroms in die Sättigung. Ein weiteres Ansteigen des Stroms führt dann zu keiner weiteren Magnetisierung der Magnetschleife und damit zu keiner weiteren Änderung des Erregerstroms, sodass ab dieser Stromschwelle der zu erfassende Strom ohne eine Kompensationsvorrichtung nicht erfasst werden kann. Die Kompensationsvorrichtung ist derart ausgestaltet, dass sie die Magnetisierung, welche der zu erfassende Strom in der Magnetschleife hervorruft, kompensiert. Dadurch wird verhindert, dass das Material der Magnetschleife in die Sättigung gerät. Für die Strommessvorrichtung bedeutet dies eine Linearisierung des Messbereichs der Strommessvorrichtung. Ein zu erfassender Strom, welcher das Material der Magnetschleife ohne die Kompensationsvorrichtung bis zur Sättigung magnetisiert hätte, kann dennoch erfasst werden. In einer solchen Ausführungsform der Strommessvorrichtung ist ein Kompensationsstrom, welcher in der Kompensationsvorrichtung fließt proportional zu dem zu erfassenden Strom und kann daher als Maß für die Stromstärke des zu erfassenden Stroms dienen. Dadurch ist gewissermaßen eine Messbereichserweiterung möglich. Der Kompensationsstrom kann mit Hilfe eines Stromsensors, zum Beispiel eines Shuntwiderstands, gemessen werden. Ein zweiter positiver Effekt bei Verwendung der Kompensationsvorrichtung besteht darin, dass die Magnetschleife sich immer im selben Arbeitspunkt befindet und so die Messung unabhängig von der Nichtlinearität der Magnetschleife macht.

In einer weiteren Ausführungsform weist die Kompensationsvorrichtung einen Kompensationsgenerator auf, welcher dazu ausgebildet ist, eine Kompensationsspannung in Abhängigkeit von der Stromstärke zu erzeugen. Die Kompensationsvorrichtung weist eine Kompensationsspule auf, welche dazu ausgebildet ist, die Magnetschleife zusätzlich mittels der erzeugten Kompensationsspannung in Gegenrichtung zu magnetisieren. Wird ein Kompensationsgenerator, zum Beispiel in Form eines Operationsverstärkers, eingesetzt, um die Kompensationsspannung zu erzeugen, kann dieser das Signal der Ermittlungsvorrichtung direkt verarbeiten. Dadurch ist ein besonders einfacher Aufbau der Strommessvorrichtung ermöglicht.

In alternativen Ausgestaltungsformen kann der Kompensationsgenerator einen digitalen Schaltkreis aufweisen, welcher die Kompensationsspannung in Abhängigkeit von digitalen Schaltsignalen oder Steuerbefehlen erzeugt. Dies ermöglicht die Integration zumindest eines Teils des Kompensationsgenerators in eine programmgesteuerte Vorrichtung, wie etwa einem Mikroprozessor. Ist in der Anwendung mit der Strommessvorrichtung eine programmgesteuerte Vorrichtung vorhanden, welche über genügend freie Rechenressourcen verfügt, um die Funktion des Kompensationsgenerators auszuführen, dann kann eine sehr kompakte Strommessvorrichtung bereitgestellt werden. Insbesondere müssen keine zusätzlichen Komponenten für den Kompensationsgenerator eingesetzt werden. Ist für den Kompensationsgenerator ein eigener digitaler Schaltkreis vorgesehen, dann kann ein sehr flexibel steuerbarer Kompensationsgenerator verwendet werden.

In einer weiteren Ausführungsform ist eine Kalibriervorrichtung vorgesehen, welche dazu ausgebildet ist, die Magnetschleife zu magnetisieren. Die Kalibriervorrichtung ist ferner dazu ausgebildet, in Abhängigkeit des sich auf Grund der Kompensationsspannung in der Kompensationsspule einstellenden Kompensationsstromes eine kalibrierte Stromstärke des durch die Strommessvorrichtung zu erfassenden Stroms zu erzeugen.

In einer Weiterbildung weist die Kompensationsvorrichtung einen zweiten Stromsensor auf, welcher dazu ausgebildet ist, den in der Kompensationsspule fließenden Kompensationsstrom zu erfassen. Die Kalibriervorrichtung weist ferner eine Steuervorrichtung auf, welche periodisch in zeitlich vorbestimmten Abständen eine erste Stromstärke des Kompensationsstromes speichert und danach ein Steuersignal zum Einschalten erzeugt. Die Kalibriervorrichtung weist ferner eine Stromquelle auf, welche in Abhängigkeit des Steuersignals einen definierten Strom erzeugt. Ferner ist eine Kalibrierspule vorgesehen, welche dazu ausgebildet ist, die Magnetschleife zusätzlich in Abhängigkeit des definierten Stroms zu magnetisieren. Die Steuervorrichtung ist derart ausgebildet, eine zweite Stromstärke des Kompensationsstromes dann zu speichern, wenn die Magnetschleife mittels des definierten Stroms magnetisiert ist. Die Steuervorrichtung ist derart ausgebildet, aus der Differenz der ersten gespeicherten Stromstärke und der zweiten gespeicherten Stromstärke eine kalibrierte Stromstärke zu bestimmen. Durch eine solche Ausgestaltung der Kalibriervorrichtung kann zu beliebigen Zeitpunkten eine Kalibrierung der Strömmessvorrichtung durchgeführt werden und dadurch eine erhöhte Genauigkeit des Messergebnisses erreicht werden. Die Steuervorrichtung erzeugt in einer solchen Anordnung ein Signal, welches die kalibrierte Stärke des zu messenden Stroms aufweist. Dieses Signal kann als analoges Signal oder als digitales Signal ausgebildet sein.

In einer weiteren bevorzugten Ausführungsform ist die Integrationsvorrichtung als analoge Schaltung ausgebildet. Dadurch ist ein sehr einfacher und robuster Aufbau der Integrationsvorrichtung möglich. Ferner kann die Integrationsvorrichtung direkt mit einer analogen Zeitmesseinrichtung und einer analogen Kompensationsvorrichtung gekoppelt werden, ohne eine Signalumwandlung durchführen zu müssen.

In einer weiteren Ausführungsform ist eine integrierte Schaltung, insbesondere eine programmgesteuerte Einrichtung, vorgesehen, welche die Integrationsvorrichtung aufweist. Eine solche integrierte Schaltung, insbesondere eine programmgesteuerte Einrichtung, ist sehr flexibel an neue Anforderungen anpassbar. Es können zum Beispiel unterschiedliche auswählbare Kennlinien oder Multiplikationsfaktoren in der integrierten Schaltung bzw. der programmgesteuerten Einrichtung hinterlegt werden, welche das Ausgangssignal der Integrationsvorrichtung beeinflussen können. Alternativ kann auch ein Programmcode, welcher die Integrationsvorrichtung aufweist, ausgetauscht werden und so deren Funktion an unterschiedliche Anforderungen adaptiert werden.

In einer Ausführungsform ist die Magnetschleife als eine luftspaltlose Magnetschleife ausgebildet. Ein luftspaltloser Aufbau der Magnetschleife bietet den Vorteil, dass die Empfindlichkeit der Strommessvorrichtung gegenüber externen Störfeldern sehr gering wird. Es kann so eine sehr genaue und robuste Strommessung bereitgestellt werden. Die erfindungsgemäße Strommessvorrichtung ist aber nicht darauf beschränkt und kann z.B. auch bei Magnetschleifen mit Luftspalt eingesetzt werden.

In einer Ausführungsform ist die Erregerspule als eine einzelne oder eine doppelte Spule ausgebildet. Dadurch kann jeweils eine für den jeweiligen Einsatzbereich geeignete Kompensationsspule bereitgestellt werden, was die Flexibilität der Strommessvorrichtung erhöht. In weiteren Ausführungsformen können auch die Kompensationsspule sowie die Kalibrierspule jeweils als eine einzelne oder als eine doppelte Spule ausgebildet sein. Denkbar wäre auch die Verwendung von Dreifach- oder allgemein von Mehrfachspulen.

In einer besonders bevorzugten Ausführungsform weist das erfindungsgemäße Verfahren zumindest zwei Betriebsmodi auf. In einem ersten Betriebsmodus lassen sich mittels der Strommessvorrichtung Gleichströme (DC) erfasst und in einem zweiten Betriebsmodus lassen sich mittels der Strommessvorrichtung Wechselströme (AC) erfasst. Die erfindungsgemäße Strommessvorrichtung ist somit zur Erfassung von AC- und DC-Strömen ausgelegt und damit universell einsetzbar. Vorzugsweise ist ein dritter Betriebsmodus vorgesehen, bei dem mittels der Strommessvorrichtung gleichzeitig Gleich- und Wechselströme erfasst werden.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung.

### INHALTSANGABE DER ZEICHNUNGEN

Die vorliegende Erfindung wird nachfolgend anhand der in den schematischen Figuren der Zeichnungen angegebenen Ausführungsbeispiele näher erläutert. Es zeigen dabei:
- Fig. 1: ein Blockdiagramm eines Ausführungsbeispiel einer erfindungsgemäßen Strommessvorrichtung;
- Fig. 2: ein Blockdiagramm eines weiteren Ausführungsbeispiels einer erfindungsgemäßen Strommessvorrichtung;
- Fig. 3: ein Blockdiagramm eines weiteren Ausführungsbeispiels einer erfindungsgemäßen Strommessvorrichtung;
- Fig. 4: ein Blockdiagramm eines Ausführungsbeispiels einer erfindungsgemäßen Erregervorrichtung;
- Fig. 5: ein Blockdiagramm eines weiteren Ausführungsbeispiels einer erfindungsgemäßen Erregervorrichtung;
- Fig. 6: ein Blockdiagramm eines erfindungsgemäßen Solarinverters;
- Fig. 7: ein Ablaufdiagramm eines Ausführungsbeispiels eines erfindungsgemäßen Verfahrens.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts Anderes ausführt ist - jeweils mit denselben Bezugszeichen versehen.

### BESCHREIBUNG VON AUSFÜHRUNGSBEISPIELEN

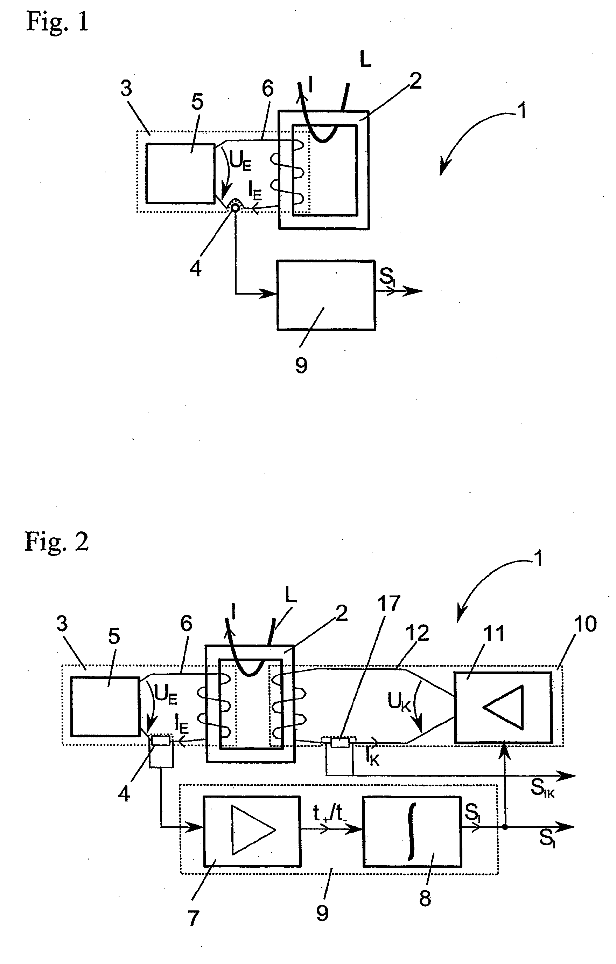

Fig. 1 zeigt ein Blockdiagramm eines Ausführungsbeispiels einer erfindungsgemäßen Strommessvorrichtung 1. Die Strommessvorrichtung 1 weist eine Magnetschleife 2 auf, welche mit einer Erregervorrichtung 3 gekoppelt ist und durch welche eine Stromleitung L verläuft. Die Erregervorrichtung 3 weist dabei einen Erregergenerator 5, welcher ein periodisches Signal U_{E} als eine periodische Spannung U_{E} erzeugt. Das periodische Signal U_{E} wird derart eingestellt, dass der Erregerstrom immer zwischen zwei Sättigungsgrenzen pendelt. Die Erregervorrichtung 3 weist ferner eine Erregerspule 6 auf, welche dazu ausgebildet ist, die Magnetschleife 2 mittels der periodischen Spannung U_{E} zu magnetisieren. Ferner ist ein erster Stromsensor 4 vorgesehen, welcher einen Erregerstrom I_{E} erfasst, welcher sich innerhalb der Erregervorrichtung 3 ausbildet, wenn diese die Magnetschleife 2 mittels der periodischen Spannung U_{E} magnetisiert. Schließlich ist eine Ermittlungsvorrichtung 9 vorgesehen, welche von dem ersten Stromsensor 4 jeweils die aktuelle Stromstärke des Erregerstromes I_{E} erhält und daraus die aktuelle Stromstärke S_{I} des Stroms I ableitet.

Die hier dargestellte Strommessvorrichtung 1 ist dazu ausgebildet Stromstärken in einem Bereich von bis zu 500 mA zu messen. In weiteren Ausführungsformen kann die Strommessvorrichtung Ströme in einem Bereich von bis zu mehreren Ampere, bevorzugterweise Ströme von bis zu 10A messen.

In dem in Fig. 1 gezeigten Ausführungsbeispiel einer erfindungsgemäßen Strommessvorrichtung 1 ist die Magnetschleife 2 als quadratische Magnetschleife ohne Luftspalt dargestellt und besteht aus einem ferromagnetischen Material. In einer weiteren Ausgestaltungsform ist die Magnetschleife 2 als runde Magnetschleife 2 ausgebildet. Denkbar wäre natürlich auch eine beliebig andere Form der Magnetschleife 2, beispielsweise eine rechteckförmige, ovale oder mehreckige Magnetschleife 2 oder eine Magnetschleife mit Luftspalt.

Die Erregervorrichtung 3 magnetisiert die Magnetschleife 2 in dem in Fig. 1 gezeigten Ausführungsbeispiel mittels der periodischen Spannung U_{E}, welche zu einem periodisch verlaufenden Erregerstrom I_{E} innerhalb der Erregerspule 6 führt. Die Frequenz der periodischen Spannung U_{E} und damit auch die Frequenz des Erregerstroms I_{E}, welche der Frequenz der periodischen Spannung U_{E} gleicht, liegen in dieser Ausführungsform bei 10 kHz. Da die magnetischen Eigenschaften der Magnetschleife 2 nicht stabil sind und sich zum Beispiel mehr oder weniger stark mit der Temperatur verändern, kann sich auch die Frequenz ändern. Dies hat aber keinen oder jedenfalls einen vernachlässigbaren Einfluss auf die Messung.

In weiteren Ausführungsformen können die Frequenzen in einem Bereich von 1 kHz bis 1 MHz, insbesondere in einem Bereich von 5 kHz bis 100 kHz, liegen.

Die periodische Spannung U_{E} in der Erregervorrichtung 3 weist zum Beispiel einen Effektivwert von 10 Volt auf. Als Erregerstrom stellt sich damit ein Strom mit einem Effektivwert von 10 mA ein. Die Amplitude der periodischen Spannung U_{E} ist für die Anwendung allerdings weniger relevant. Wesentlich ist, dass mittels der Spannung U_{E} der notwendige Erregerstrom einstellbar ist.

Der erste Stromsensor 4 aus Fig. 1 ist als direkt messender passiver erster Stromsensor 4 ausgebildet. Ein direkt messender passiver erster Stromsensor 4 ermöglicht eine besonders einfache und genaue Erfassung des Erregerstroms I_{E}.

Fig. 2 zeigt ein Blockdiagramm eines weiteren Ausführungsbeispiels einer erfindungsgemäßen Strommessvorrichtung 1.

Die in Fig. 2 gezeigte Strommessvorrichtung 1 unterscheidet sich von der in Fig. 1 gezeigten Strommessvorrichtung 1 dadurch, dass die Ermittlungsvorrichtung 9 eine Zeitmessvorrichtung 7 aufweist, welche das Signal des ersten Stromsensors 4 erhält und daraus zwei Signale t₊ und t- erzeugt, welche von einer Integrationsvorrichtung 8 ausgewertet werden, welche daraus die Stromstärke S_{I} des zu erfassenden Stroms I ableitet. Die Stromstärke S_{I} wird direkt als Ausgangsgröße der Ermittlungsvorrichtung 9 nach Außen geführt und kann in einer Ausgestaltungsform als Maß für die Stärke des Stromes I dienen. Die Stromstärke S_{I} wird ferner einer Kompensationsvorrichtung 10 zugeführt, welche einen Kompensationsgenerator 11 und eine Kompensationsspule 12 aufweist. Der Kompensationsgenerator 11 erzeugt in Abhängigkeit von der Stromstärke S_{I} eine Kompensationsspannung U_{K}. Die Kompensationsspule 12 magnetisiert die Magnetschleife 2 mittels dieser Kompensationsspannung U_{K}, wobei sich in der Kompensationsspule 12 ein Kompensationsstrom I_{K} einstellt. Es ist weiterhin ein zweiter Stromsensor 17 vorgesehen, welcher die Stärke S_{IK} des Kompensationsstroms I_{K}, welcher in der Kompensationsspule 12 fließt, erfasst. In Fig. 2 sind der erste Stromsensor 4 als erster Shuntwiderstand 4 und der zweite Stromsensor 17 und als zweiter Shuntwiderstand 17 vorgesehen.

Der Kompensationsgenerator 11 ist so dimensioniert, dass er die Kompensationsspannung U_{K} derart generiert, dass der durch die Kompensationsspule 12 innerhalb der Magnetspule 2 erzeugte magnetische Fluss das umgekehrte Vorzeichen und den gleichen Betrag aufweist, wie der magnetischen Fluss, welcher durch den Strom I, welcher in der Stromleitung L fließt, in der Magnetschleife 2 erzeugt wird. Dadurch wird der magnetische Fluss in der Magnetschleife 2 zu Null ausgeregelt. In einer solchen Anordnung dient die Stärke S_{IK} des durch die Kompensationsspule 12 fließenden Kompensationsstroms I_{K} als Maß für die Stärke des Stroms I.

In der in Fig. 2 dargestellten Ausführungsform ist die Zeitmessvorrichtung 7 als analoger Komparator 7 ausgebildet, welcher die Spannung erfasst, welche über den ersten Shuntwiderstand 4 abfällt, und anstatt zweier Signale t₊ und t₋ ein kombiniertes Signal t₊/t₋ ausgibt, welches positiv ist, falls die Spannung über dem ersten Shuntwiderstand 4 positiv ist und welches negativ ist, falls die Spannung über dem ersten Shuntwiderstand 4 negativ ist.

In einer weiteren Ausführungsform kann die Zeitmessvorrichtung 7 als Mikrocontroller ausgebildet sein, welcher die Spannung, welche über dem ersten Shuntwiderstand 4 abfällt, über einen Analog/Digital-Wandler erfasst und zwei Signale erzeugt. Das erste Signal gibt die Zeitdauer t₊ an, für die der Erregerstrom I_{E} innerhalb der letzten Periode des Erregerstroms I_{E} positiv war und das zweite Signal gibt die Zeitdauer t₋ an, für die der Erregerstrom I_{E} innerhalb der letzten Periode des Erregerstroms I_{E} negativ war. Alternativ erfasst der Mikrocontroller die Spannung über dem ersten Shuntwiderstand 4 mittels eines Komparatoreingangs. Dabei kann der Komparatoreingang des Mikrocontrollers direkt mit einem Zähler des Mikrocontrollers verbunden sein. Die Zeiterfassung geschieht dann unabhängig von dem Programmablauf innerhalb des Mikrocontrollers.

Die Integrationsvorrichtung 8 weist in Fig. 2 einen Tiefpassfilter auf, welcher das Signal des analogen Komparators 7 empfängt. Wird dieses Signal durch den Tiefpassfilter, welcher eine integrierende Übertragungsfunktion aufweist, gefiltert, erhält man ein Signal, welches proportional zu dem Gleichanteil des Erregerstromes I_{E} ist und damit auch proportional zu dem zu messenden Strom I ist.

In einer weiteren Ausführungsform kann die Integrationsvorrichtung 8 ebenfalls als Mikrocontroller 8 ausgeführt sein. In einer bevorzugten Ausführungsform weist ein Mikrocontroller sowohl die Zeitmessvorrichtung 7 als auch die Integrationsvorrichtung 8 auf. In solch einer Ausführungsform ist die Integrationsvorrichtung 8 als Programmmodul innerhalb des Mikrocontrollers vorgesehen. Die Integrationsvorrichtung 8 erzeugt dann für jede Periode des Erregerstroms I_{E} ein Ausgangssignal, welches der Stromstärke S_{I} des Erregerstroms I_{E} entspricht. Die Integrationsvorrichtung 8 kann dieses Signal über einen Digital/Analog-Wandler des Mikrocontrollers als analoges Signal erzeugen. Alternativ kann die Integrationsvorrichtung 8 dieses Signal als digitales Signal, direkt über Ausgabepins des Mikrocontrollers oder über einen digitalen Bus, mit welchem der Mikrocontroller gekoppelt ist, ausgeben. Werden die Zeitmessvorrichtung 7 und die Integrationsvorrichtung 8 in einer Strommessvorrichtung ohne Kompensationsvorrichtung 10, wie in Fig. 1 dargestellt, durch einen Mikrocontroller implementiert, kann das Ausgabesignal des Mikrocontrollers direkt als Maß für die Stromstärke des Stroms I genutzt werden. Denkbar wäre auch, das Signal S_{I} an der Integrationsvorrichtung 8 als Maß für die Stromstärke I zu benutzen.

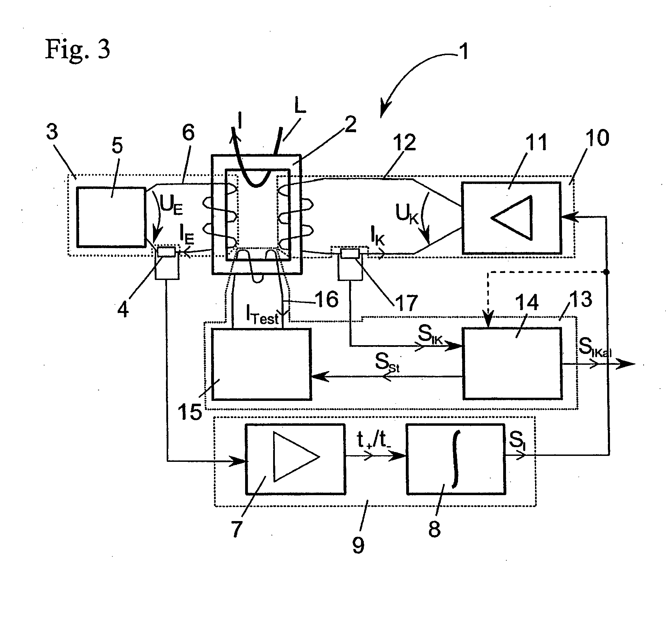

Fig. 3 zeigt ein Blockdiagramm eines weiteren Ausführungsbeispiels einer erfindungsgemäßen Strommessvorrichtung 1. Dabei unterscheidet sich die in Fig. 3 dargestellt Ausführungsform einer erfindungsgemäßen Strommessvorrichtung 1 von der in Fig. 2 dargestellten Ausführungsform dadurch, dass die durch den zweiten Stromsensor 17 erfasste Stromstärke S_{IK} einer Kalibriervorrichtung 13 zugeführt wird. In einer alternativen Ausführungsform kann der Kalibriervorrichtung 13 alternativ oder zusätzlich das Signal S_{I} zugeführt werden. Dies ist in Fig. 3 durch einen gestrichelten Pfeil dargestellt. Die Kalibriervorrichtung 13 weist dabei eine Steuervorrichtung 14 auf, welche dazu ausgebildet ist, mindestens zwei Werte der Stromstärke S_{IK} des Kompensationsstroms I_{K} oder zwei Werte des Signals S_{I} zu speichern und deren Differenz zu bilden. Ferner ist die Steuervorrichtung 14 mit einer Stromquelle 15 gekoppelt, welche einen definierten Strom I_{Test} erzeugt, und dazu ausgebildet, der Stromquelle 15 ein Steuersignal S_{St} zum Einschalten zu übermitteln. Die Stromquelle 15 ist mit einer Kalibrierspule 16 gekoppelt, welche die Magnetschleife 2 mittels des definierten Stroms I_{Test} magnetisieren kann.

Die Steuervorrichtung 14 ist in der in Fig. 3 dargestellten Ausführungsform als programmgesteuerte Einrichtung ausgeführt und bestimmt eine kalibrierte Stromstärke S_{IKal} des Stroms I, welcher durch den Stromleiter L fließt. Dazu speichert die Steuervorrichtung 14 einen ersten Wert der Stromstärke S_{IK}, während die Stromquelle 15 abgeschaltet ist. Danach erzeugt die Steuervorrichtung 14 das Steuersignal S_{St} zum Einschalten und übermittelt dies an die Stromquelle 15. Auf Grund des durch die Kalibrierspule 16 fließenden Stroms I_{Test} verändert sich die Stromstärke S_{IK} des Kompensationsstroms I_{K}. Den veränderten zweiten Wert der Stromstärke S_{IK} des Kompensationsstroms I_{K} zieht die Steuervorrichtung 14 von dem gespeicherten ersten Wert der Stromstärke S_{IK} ab und vergleicht das Ergebnis der Differenzbildung mit einem gespeicherten Referenzwert. Weicht der Referenzwert von diesem Ergebnis ab, weist die Strommessvorrichtung eine Steigungsänderung auf. Die Steuervorrichtung 14 berechnet diese Steigungsänderung indem sie das Referenzwert durch das Ergebnis der Differenzbildung dividiert. Hat die Steuervorrichtung 14 eine Steigung berechnet, bestimmt sie die kalibrierte Stromstärke S_{IKal}, indem sie diese Steigung mit dem Wert der Stromstärke S_{IK} multipliziert. Den Wert der kalibrierten Stromstärke S_{IKal} gibt die Steuervorrichtung 14 in digitaler Form als Signal auf einem digitalen Bus oder über Signalpins der Steuervorrichtung 14 aus. Ferner kann die Steuervorrichtung 14 den Wert der kalibrierten Stromstärke S_{IKal} über einen Digital/Analog-Wandler als analoges Signal ausgeben.

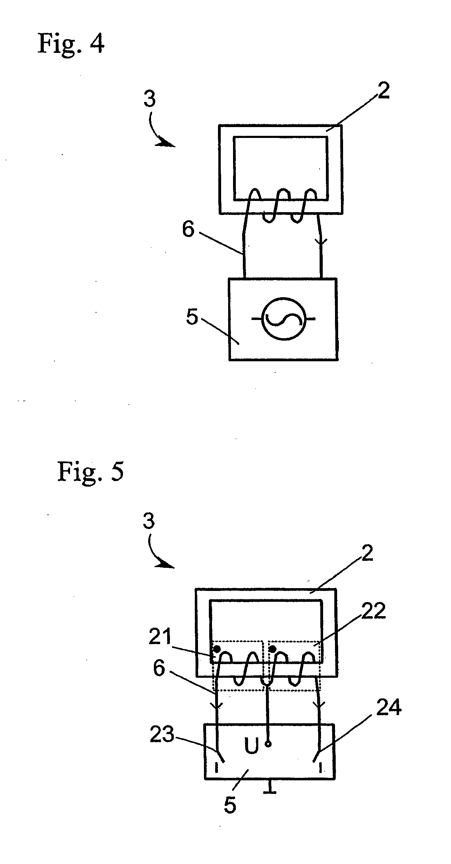

Fig. 4 zeigt ein Blockdiagramm eines Ausführungsbeispiels einer Erregervorrichtung 3.

Die Erregervorrichtung 3 aus Fig. 4 weist einen Erregergenerator 5 auf, welcher mit einer Spule 6 gekoppelt ist, welche dazu ausgebildet ist, eine Magnetschleife 2 zu magnetisieren. Der Erregergenerator 5 ist in Fig. 4 als Wechselspannungsgenerator 5 ausgeführt und die Erregerspule 6 ist über zwei elektrische Verbindungen mit dem Wechselspannungsgenerator 5 gekoppelt. Der Wechselspannungsgenerator 5 kann als ein Transformator ausgeführt sein, der eine für die Erregerspule 6 geeignete Wechselspannung aus einer Quellspannung, welche ebenfalls eine Wechselspannung ist, erzeugt. Alternativ kann der Wechselspannungsgenerator 5 eine Vollbrücke aufweisen, mittels welcher der Wechselspannungsgenerator 5 aus einer Gleichspannung eine Wechselspannung erzeugen kann.

Fig. 5 zeigt ein Blockdiagramm eines weiteren Ausführungsbeispiels einer erfindungsgemäßen Erregervorrichtung 3. Im Unterschied zu der in Fig. 4 gezeigten Erregervorrichtung 3 ist der Erregergenerator 5 in Fig. 5 über zumindest zwei, beispielsweise drei oder vier elektrische Verbindungen mit der Erregerspule 6 gekoppelt. Eine erste elektrische Verbindung kontaktiert die Spulenmitte der Erregerspule 6 und ist in dem Erregergenerator 5 mit einer Versorgungsgleichspannung verbunden. Die zwei weiteren elektrischen Verbindungen verbinden jeweils einmal ein Ende und einmal ein Anfang der der Erregerspule 6 mit je einem Schalter 23 und 24 innerhalb des Erregergenerators 5. Die Erregerspule 6 wird durch diese Art der Kopplung mit dem Erregergenerator 5 in zwei Spulen 21 und 22 geteilt, welche die Magnetschleife 2 abwechselnd und in unterschiedlichen Richtungen magnetisieren. Die Punkte bezeichnen die beide Anfänge oder die beide Enden der Spulenanordnung. Wird der linke Schalter 23 geschlossen erzeugt dies einen Stromfluss in der linken Spule 21. Wird der rechte Schalter 24 geschlossen, erzeugt dies einen Stromfluss in der rechten Spule 22 in entgegen gesetzter Richtung zu dem Stromfluss in der linken Spule 21. Da die Spulen 21 und 22 die Magnetschleife 2 gleichsinnig magnetisieren, erzeugt eine abwechselnde Bestromung der linken Spule 21 und der rechten Spule 22 daher eine wechselnde Magnetisierung der Magnetschleife 2.

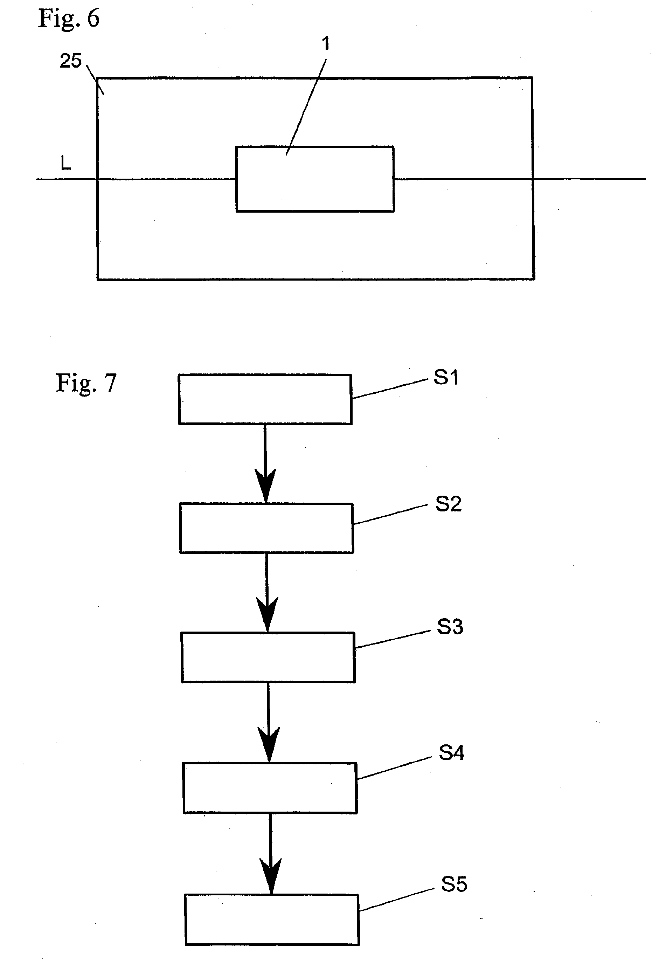

Fig. 6 zeigt ein Blockdiagramm eines erfindungsgemäßen Solarinverters 25. Der in Fig. 6 gezeigte Solarinverter 25 weist eine Strommessvorrichtung 1 und einen Leiter L, welcher durch den Solarinverter 25 und die Strommessvorrichtung 1 verläuft, auf.

Fig. 7 zeigt ein Ablaufdiagramm eines Ausführungsbeispiels eines erfindungsgemäßen Verfahrens zum Erfassen eines Stroms I.

In einem ersten Schritt S1 wird eine Magnetschleife 2 mittels eines periodischen Signals U_{E} magnetisiert, wobei die Magnetschleife 2 dazu ausgebildet ist eine Stromleitung L aufzunehmen. Die Stromleitung L führt in dem gezeigten Ausführungsbeispiel den zu erfassenden Strom I.

In einem zweiten Schritt S2 wird die Stromleitung L durch die Magnetschleife 2 geführt. Konstruktionsbedingt erfasst die erfindungsgemäße Strommessvorrichtung 1 primär Ströme, welche innerhalb der Magnetschleife 2 fließen. Dadurch wird die Strommessvorrichtung 1 unempfindlich gegenüber externen Störfeldern.

In einem dritten Schritt S3 fließt der zu erfassende Strom I durch die Stromleitung L.

In einem vierten Schritt S4 wird ein Erregerstrom I_{E} erfasst, welcher mittels des periodischen Signals U_{E} und/oder auf mittels des Stroms I innerhalb der Erregervorrichtung 3 erzeugt wird.

In einem letzten Schritt S5 wird eine Stromstärke S_{I} des zu erfassenden Stroms I bestimmt. Dies geschieht, indem die Verschiebung des erfassten Erregerstroms I_{E} auf der Stromachse ermittelt wird, welche proportional zu dem Strom I ist.

Ist der Erregerstrom I_{E} als sinusförmiges Signal ausgebildet, so ergibt der Verlauf des Erregerstroms, wenn man ihn in einem Zeit/Strom-Diagramm darstellt einen zu null Ampere symmetrischen Sinusverlauf, wenn kein Strom I fließt. Fließt ein Strom I durch die Stromleitung L so verschiebt sich der Sinusverlauf in dem Zeit/Strom-Diagramm in Abhängigkeit von dem Vorzeichen des Stroms I nach oben oder nach unten und die Verschiebung kann als Maß für den Strom I dienen.

Diese Verschiebung kann auf unterschiedliche Weisen ermittelt werden. Es kann zum Beispiel der Gleichanteil des Erregerstroms I_{E} bestimmt werden. Ferner kann das Verhältnis der Zeitdauer, welche der Erregerstrom gegenüber der Periodendauer positiv oder negativ ist, zur gesamten Periodendauer berechnet werden. In noch einer weiteren Ausführungsform kann die Differenz der Zeitdauer, welche der Erregerstrom I_{E} positiv ist, und der Zeitdauer, welche der Erregerstrom I_{E} negativ ist, integriert werden.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar.

In einer alternativen Ausführungsform wird die Stromleitung zweimal durch die Magnetschleife geführt, wobei ein elektrischer Stromverbraucher in der Schlaufe des Stromleiters liegt, welche sich zwischen einem zu dem elektrischen Stromverbraucher hin- und einem von dem elektrischen Stromverbraucher zurückführenden Leiterzweig des Stromleiters ergibt. In dieser Ausführungsform erfasst die erfindungsgemäße Strommessvorrichtung einen Differenzstrom zwischen dem hin- und dem rückführenden Leiterzweig. Weist der elektrische Stromverbraucher keinen Isolationsfehler auf, fließt der gleiche Strom durch den hin- und den rückführenden Leiterzweig des Stromleiters und die Strommessvorrichtung erfasst einen Differenzstrom von Null Ampere. Sobald der elektrische Stromverbraucher aber einen Isolationsfehler oder einen anderen elektrischen Fehler aufweist, durch welchen ein elektrischer Strom aus dem Verbraucher gegen Masse oder andere elektrisch leitenden Vorrichtungen abfließt, erkennt die Strommessvorrichtung eine Differenz zwischen den Strömen der hin- und rückführenden Leiterzweige des Leiters. Die Ausgabe der Strommessvorrichtung entspricht dann diesem Differenzstrom.

### Bezugszeichenliste

- 1: Strommessvorrichtung
- 2: Magnetschleife
- 3: Erregervorrichtung
- 4: erster Stromsensor
- 5: Erregergenerator
- 6: Erregerspule
- 7: Zeitmessvorrichtung
- 8: Integrationsvorrichtung
- 9: Ermittlungsvorrichtung
- 10: Kompensationsvorrichtung
- 11: Kompensationsgenerator
- 12: Kompensationsspule
- 13: Kalibriervorrichtung
- 14: Steuervorrichtung
- 15: Stromquelle
- 16: Kalibrierspule
- 17: zweiter Stromsensor
- 21: linke Spule
- 22: rechte Spule
- 23: linker Schalter
- 24: rechter Schalter
- 25: Solarinverter

- L: Stromleitung
- I: Strom
- U_{E}: periodisches Signal, Spannungssignal
- I_{E}: Erregerstrom
- t₊, t₋: Zeitdauern
- t₊/t₋: Zeitdauersignal
- S_{I}: Stromstärke
- S_{IK}: Stromstärke
- S_{IKal}: kalibrierte Stromstärke
- U_{K}: Kompensationsspannung
- I_{K}: Kompensationsstrom
- S_{St}: Steuersignal
- I_{Test}: definierter Strom

- S1 - S5: Verfahrensschritte

## Patentansprüche

1. Strommessvorrichtung (1) zum Erfassen eines durch eine Stromleitung (L) fließenden Stroms (I),
mit einer Magnetschleife (2) zur Aufnahme der Stromleitung (L);
mit einer Erregervorrichtung (3), welche dazu ausgebildet ist, die Magnetschleife (2) mittels eines solchen periodischen Signals (U_{E}) zu magnetisieren, dass die Magnetisierung der Magnetschleife (2) immer zwischen zwei Sättigungsgrenzen pendelt;
mit einem ersten Stromsensor (4), welcher dazu ausgebildet ist, einen auf Grund des periodischen Signals (U_{E}) und/oder des zu erfassenden Stroms (I) in der Erregervorrichtung (3) fließenden Erregerstrom (I_{E}) zu erfassen;
mit einer Ermittlungsvorrichtung (9), welche eine durch den Strom (I) hervorgerufene Verschiebung des erfassten Erregerstroms (I_{E}) auf der Stromachse ermittelt und daraus die Stromstärke (S_{I}) des zu erfassenden Stroms (I) ableitet
mit einer Kalibriervorrichtung (13), welche dazu ausgebildet ist, die Magnetschleife (2) zu magnetisieren und in Abhängigkeit des sich auf Grund der Kompensationsspannung (UK) in der Kompensationsspule (12) einstellenden Kompensationsstromes (IK) eine kalibrierte Stromstärke (SIKal) des durch die Strommessvorrichtung (1) zu messenden Stroms (I) zu erzeugen.

2. Strommessvorrichtung nach Anspruch 1,
**dadurch gekennzeichnet,**
**dass** die Erregervorrichtung (3) einen Erregergenerator (5) aufweist, welcher als periodisches Signal (U_{E}) eine periodische Spannung (U_{E}) generiert, und welcher eine Erregerspule (6) aufweist, welche dazu ausgebildet ist, die Magnetschleife (2) mittels der periodischen Spannung (U_{E}) zu magnetisieren.

3. Strommessvorrichtung nach einem der vorherigen Ansprüche,
**dadurch gekennzeichnet,**
**dass** die Ermittlungsvorrichtung (9) eine Zeitmessvorrichtung (7) aufweist, welche für jede Periode des periodischen Signals (UE) eine erste Zeitdauer (t+) misst, in welcher der erfasste Erregerstrom (IE) einen positiven Betrag aufweist, und welche für jede Periode des periodischen Signals (UE) eine zweite Zeitdauer (t-) misst, in welcher der erfasste Erregerstrom (IE) einen negativen Betrag aufweist, und dass die Ermittlungsvorrichtung (9) eine Integrationsvorrichtung (8) aufweist, welche als Maß für den zu erfassenden Strom (I) eine Differenz zwischen der gemessenen ersten Zeitdauer (t+) und der gemessenen zweiten Zeitdauer (t-) integriert.

4. Strommessvorrichtung nach einem der vorherigen Ansprüche,
**dadurch gekennzeichnet,**
**dass** die Ermittlungsvorrichtung (9) eine Filtervorrichtung aufweist, welche als Maß für den zu erfassenden Strom (I) einen Gleichanteil des erfassten Erregerstroms (IE) aus dem erfassten Erregerstrom (IE) filtert.

5. Strommessvorrichtung nach einem der vorherigen Ansprüche,
**dadurch gekennzeichnet,**
**dass** eine Kompensationsvorrichtung (10) vorgesehen ist, welche dazu ausgebildet ist, die Magnetschleife (2) zusätzlich in Abhängigkeit von der ermittelten Stromstärke (S_{I}) in Gegenrichtung zu magnetisieren.

6. Strommessvorrichtung nach einem der vorherigen Ansprüche,
**dadurch gekennzeichnet,**
**dass** die Kompensationsvorrichtung (10) einen Kompensationsgenerator (11) aufweist, welcher dazu ausgebildet ist, eine Kompensationsspannung (U_{K}) in Abhängigkeit von der Stromstärke (S_{I}) zu erzeugen, und dass die Kompensationsvorrichtung (10) eine Kompensationsspule (12) aufweist, welche dazu ausgebildet ist, die Magnetschleife (2) zusätzlich mittels der erzeugten Kompensationsspannung (U_{K}) in Gegenrichtung zu magnetisieren.

7. Strommessvorrichtung nach einem der vorherigen Ansprüche,
**dadurch gekennzeichnet,**
**dass** die Kompensationsvorrichtung (10) einen zweiten Stromsensor (17) aufweist, welcher dazu ausgebildet ist, den in der Kompensationsspule (12) fließenden Kompensationsstrom (I_{K}) zu erfassen.

8. Strommessvorrichtung nach einem der vorherigen Ansprüche,
**dadurch gekennzeichnet,**
**dass** die Kalibriervorrichtung (13) ferner aufweist:
eine Steuervorrichtung (14), welche periodisch in zeitlich vorbestimmten Abständen eine erste Stromstärke (S_{IK}) des Kompensationsstromes (I_{K}) speichert und danach ein Steuersignal (S_{St}) zum Einschalten erzeugt;
eine Stromquelle (15), welche in Abhängigkeit des Steuersignal (S_{St}) einen definierten Strom (I_{Test}) erzeugt;
eine Kalibrierspule (16), welche dazu ausgebildet ist, die Magnetschleife (2) zusätzlich in Abhängigkeit des definierten Stroms (I_{Test}) zu magnetisieren;
wobei die Steuervorrichtung (14) derart ausgebildet ist, eine zweite Stromstärke (S_{IK}) des Kompensationsstromes (I_{K}) dann zu speichern, wenn die Magnetschleife (2) mittels des definierten Stroms (I_{Test}) magnetisiert ist, und wobei die Steuervorrichtung (14) derart ausgebildet ist, aus der Differenz der ersten gespeicherten Stromstärke und der zweiten gespeicherten Stromstärke eine kalibrierte Stromstärke (S_{IKal}) zu bestimmen.

9. Strommessvorrichtung nach einem der vorherigen Ansprüche,
**dadurch gekennzeichnet,**
**dass** die Integrationsvorrichtung (8) als analoge Schaltung ausgebildet ist.

10. Strommessvorrichtung nach einem der vorherigen Ansprüche,
**dadurch gekennzeichnet,**
**dass** eine integrierte Schaltung, insbesondere eine programmgesteuerte Einrichtung, vorgesehen ist, welche die Integrationsvorrichtung (8) aufweist.

11. Strommessvorrichtung nach einem der vorherigen Ansprüche,
**dadurch gekennzeichnet,**
**dass** die Magnetschleife (2) als eine luftspaltlose Magnetschleife (2) ausgebildet ist.

12. Strommessvorrichtung nach einem der vorherigen Ansprüche,
**dadurch gekennzeichnet,**
**dass** die Erregerspule (6) als eine einzelne oder eine doppelte Spule ausgebildet ist.

13. Solarinverter, insbesondere transformatorloser Solarinverter,
mit einer Strommessvorrichtung (1) nach einem der Ansprüche 1 bis 12.

14. Verfahren zum Erfassen eines Stroms (I), insbesondere mittels einer Strommessvorrichtung (1) nach einem der Ansprüche 1 bis 13, mit den Schritten:
Magnetisieren (S1) einer Magnetschleife (2) zur Aufnahme einer Stromleitung (L) mittels eines periodischen Signals (U_{E}) durch eine Erregervorrichtung (3);
Durchführen (S2) einer Stromleitung (L) durch die Magnetschleife (2);
Bestromen (S3) der Stromleitung (L) mit dem zu erfassenden Strom (I);
Erfassen (S4) eines Erregerstromes (I_{E}), welcher auf Grund des periodischen Signals (U_{E}) und/oder auf Grund des Stroms (I) in der Erregervorrichtung (3) fließt;
periodisches Speichern einer ersten Stromstärke (S_{IK}) des Kompensationsstromes (I_{K}), wobei die Magnetschleife (2) dabei nicht zusätzlich mittels eines definierten Teststromes (I_{Test}) magnetisiert ist;
darauf folgend Einschalten einer Stromquelle (15) welche den definierten Teststrom (I_{Test}) erzeugt;
Magnetisieren der Magnetschleife (2) durch eine Kalibrierspule (16), mittels des definierten Teststroms (I_{Test});
Speichern einer zweiten Stromstärke (S_{IK}) des Kompensationsstromes (I_{K}), welcher in der Kompensationsspule (12) fließt, wobei die Magnetschleife (2) dabei zusätzlich mittels des definierten Teststromes (I_{Test}) magnetisiert ist;
Ableiten (S5) einer Stromstärke (S_{I}) des zu erfassenden Stroms (I) aus der Verschiebung des erfassten Erregerstroms (I_{E}) auf der Stromachse;
Bestimmen einer kalibrierten Stromstärke (S_{IKal}) mittels der Differenz der ersten Stromstärke und der zweiten Stromstärke des Kompensationsstromes (I_{K}) durch die Steuervorrichtung (14).

15. Verfahren nach Anspruch 14,
**dadurch gekennzeichnet,**
**dass** das Ableiten der Stromstärke (S_{I}) die weiteren Schritte aufweist:
Messen einer ersten Zeitdauer (t₊), in welcher der Erregerstrom (I_{E}) einen positiven Betrag aufweist, und einer zweiten Zeitdauer (t₋), in welcher der Erregerstrom (I_{E}) einen negativen Betrag aufweist;
Integrieren der Differenz zwischen der ersten Zeitdauer (t₊) und der zweiten Zeitdauer (t₋); und
Bestimmen der Stromstärke (S_{I}) aus dem Integrationsergebnis.

## Claims

1. Current measurement device (1) for detecting a current (I) flowing through a power line (L),
comprising a magnetic loop (2) for receiving the power line (L);
comprising an exciter device (3), which is configured to magnetise the magnetic loop (2) with a periodic signal (U_{E}) such that the magnetisation of the magnetic loop (2) always oscillates between two saturation limits; comprising a first current sensor (4), which is configured to detect an excitation current (I_{E}) flowing in the exciter device (3) as a result of the periodic signal (U_{E}) and/or of the current (I) to be detected; comprising a detection device (9), which detects a shift, induced by the current (I), in the detected excitation current (I_{E}) on the current axis, and derives therefrom the intensity (S_{I}) current (I) to be detected; comprising a calibration device (13), which is configured to magnetise the magnetic loop (2) and, as a function of the compensation current (I_{K}) which occurs as a result of the compensation voltage (U_{K}) in the compensation coil (12), to bring about a calibrated intensity (S_{IKal}) of the current (I) to be measured by the current measurement device (1).

2. Current measurement device according to claim 1,
**characterised in that**
the exciter device (3) comprises an exciter generator (5), which generates a periodic voltage (U_{E}) as a periodic signal and which comprises an exciter coil (6), which is configured to magnetise the magnetic loop (2) using the periodic voltage (U_{E}).

3. Current measurement device according to either of the preceding claims,
**characterised in that**
the detection device (9) comprises a time measurement device (7), which measures, for each period of the periodic signal (U_{E}), a first duration (t₊) within which the detected generator current (I_{E}) has a positive value, and which measures, for each period of the periodic signal (U_{E}), a second duration (t₋) within which the detected generator current (I_{E}) has a negative value, and **in that** the detection device (9) comprises an integration device (8) which integrates the difference between the measured first duration (t₊) and the measured second duration (t-) as a measure of the current (I) to be detected.

4. Current measurement device according to any of the preceding claims,
**characterised in that**
the generator device (9) comprises a filter device which filters a constant component of the detected excitation current (I_{E}) out of the detected excitation current (I_{E}) as a measure of the detected current (I).

5. Current measurement device according to any of the preceding claims,
**characterised in that**
a compensation device (10) is provided, which is configured additionally to magnetise the magnetic loop (2) in the counter direction as a function of the detected current intensity (S_{I}).

6. Current measurement device according to any of the preceding claims,
**characterised in that**
the compensation device (10) comprises a compensation generator (11), which is configured to produce a compensation voltage (U_{K}) as a function of the current intensity (S_{I}), and **in that** the compensation device (10) comprises a compensation coil (12), which is configured additionally to magnetise the magnetic loop (2) in the counter direction by means of the produced compensation voltage (U_{E}).

7. Current measurement device according to any of the preceding claims,
**characterised in that**
the compensation device (10) comprises a second current sensor (17), which is configured to detect the compensation current (I_{K}) flowing in the compensation coil (12).

8. Current measurement device according to any of the preceding claims,
**characterised in that**
the calibration device (13) further comprises:
a control device (14), which periodically stores a first current intensity (S_{IK}) of the compensation current (I_{K}) at predetermined intervals and subsequently produces a control signal (S_{St}) for switching on;
a power source (15), which produces a defined current (I_{Test}) as a function of the control signal (S_{St});
a calibration coil (16), which is configured additionally to magnetise the magnetic loop (2) as a function of the defined current (I_{Test});
the control device (14) being configured to store a second current intensity (S_{IK}) of the compensation current (I_{K}) when the magnetic loop (2) is magnetised using the defined current (I_{Test}), and the control device (14) being configured to determine a calibrated current intensity (S_{IKal}) from the difference between the first stored current intensity and the second stored current intensity.

9. Current measurement device according to any of the preceding claims,
**characterised in that**
the integration device (8) is configured as an analogue circuit.

10. Current measurement device according to any of the preceding claims,
**characterised in that**
an integrated circuit, in particular a program-controlled device, is provided, which comprises the integration device (8).

11. Current measurement device according to any of the preceding claims,
**characterised in that**
the magnetic loop (2) is configured as a closed magnetic loop (2).

12. Current measurement device according to any of the preceding claims,
**characterised in that**
the exciter coil (6) is configured as a single or a double coil.

13. Solar inverter, in particular a solar inverter without a transformer,
comprising a current measurement device (1) according to any of claims 1 to 12.

14. Method for detecting a current (I), in particular using a current measurement device (1) according to any of claims 1 to 13, comprising the steps of:
magnetising (S1) a magnetic loop (2) for receiving a power line (L) with a periodic signal (U_{E}), by way of a generator device (3);
passing (S2) a power line (L) through the magnetic loop (2) ;
applying (S3) the current (I) to be detected to the power line (L);
detecting (S4) an excitation current (I_{E}), which flows as a result of the periodic signal (U_{E}) and/or of the current (I) in the exciter device (3);
periodically storing a first current intensity (S_{IK}) of the compensation current (I_{K}), without the magnetic loop (2) additionally being magnetised with a defined test current (I_{Test});
subsequently switching on a power source (15), which produces the defined test curent (I_{Test});
magnetising the magnetic loop (2) with the defined test current (I_{Test}), by way of a calibration coil (16);
storing a second current intensity (S_{IK}) of the compensation current (I_{K}) which flows in the compensation coil (12), the magnetic loop (2) additionally being magnetised with the defined test current (I_{Test});
deriving (S5) a current intensity (S_{I}) of the current (I) to be detected from the shift in the detected generator current (I_{E}) on the current axis;
determining a calibrated current intensity (S_{IKal}) using the difference between the first current intensity and
the second current intensity of the compensation current (I_{K}), by way of the control device (14).

15. Method according to claim 14,
**characterised in that**
deriving the current intensity (S_{I}) comprises the further steps of:
measuring a first duration (t₊) in which the exciter current (I_{E}) has a positive value and a second duration (t₋) in which the exciter current (I_{E}) has a negative value;
integrating the difference between the first duration (t₊) and the second duration (t₋); and
determining the current intensity (S_{I}) from the integration result.

## Revendications

1. Dispositif de mesure de courant (1) destiné à détecter un courant (I) circulant dans une ligne de courant (L), comportant une boucle magnétique (2) destinée à recevoir la ligne de courant (L) ;
comportant un dispositif d'excitation (3) réalisé pour magnétiser la boucle magnétique (2) au moyen d'un signal périodique (U_{E}) tel que la magnétisation de la boucle magnétique (2) oscille toujours entre deux seuils de saturation ;
comportant un premier détecteur de courant (4) réalisé pour détecter un courant d'excitation (I_{E}) circulant dans le dispositif d'excitation (3) en raison du signal périodique (U_{E}) et/ou du courant (I) à détecter ; comportant un dispositif de détermination (9) qui détermine un déplacement, provoqué par le courant (I), du courant d'excitation (I_{E}) détecté sur l'axe du courant, et en déduit l'intensité (S_{I}) du courant (I) à détecter ;
comportant un dispositif de calibrage (13), réalisé pour magnétiser la boucle magnétique (2) et pour générer, en fonction du courant de compensation (I_{K}) qui s'adapte dans la bobine de compensation (12) en raison de la tension de compensation (U_{K}), une intensité calibrée (S_{IKal}) du courant (I) à mesurer par le dispositif de mesure de courant (1).

2. Dispositif de mesure de courant selon la revendication 1, **caractérisé en ce que**
le dispositif d'excitation (3) présente un générateur d'excitation (5) qui génère une tension périodique (U_{E}) pour servir de signal périodique (U_{E}) et qui présente une bobine d'excitation (6) réalisée pour magnétiser la boucle magnétique (2) au moyen de la tension périodique (U_{E}).

3. Dispositif de mesure de courant selon une des revendications précédentes, **caractérisé en ce que** le dispositif de détermination (9) présente un dispositif de chronométrage (7) qui mesure, pour chaque période du signal périodique (U_{E}), une première durée (t₊) dans laquelle le courant d'excitation (I_{E}) détecté présente une valeur positive et qui, pour chaque période du signal périodique (U_{E}), mesure une seconde durée (t_) dans laquelle le courant d'excitation (I_{E}) détecté présente une valeur négative, et **en ce que** le dispositif de détermination (9) présente un dispositif d'intégration (8) qui intègre, pour servir de mesure du courant (I) à détecter, une différence entre la première durée (t₊) mesurée et la seconde durée (t₋) mesurée.

4. Dispositif de mesure de courant selon une des revendications précédentes, **caractérisé en ce que** le dispositif de détermination (9) présente un dispositif de filtrage qui, pour servir de mesure du courant (I) à détecter, filtre à partir du courant d'excitation (I_{E}) détecté une composante continue du courant d'excitation (I_{E}) détecté.

5. Dispositif de mesure de courant selon une des revendications précédentes, **caractérisé en ce qu'** un dispositif de compensation (10) est prévu et réalisé pour magnétiser en plus en sens inverse la boucle magnétique (2) en fonction de l'intensité (S_{I}) déterminée.

6. Dispositif de mesure de courant selon une des revendications précédentes, **caractérisé en ce que** le dispositif de compensation (10) présente un générateur de compensation (11) réalisé pour générer une tension de compensation (U_{K}) en fonction de l'intensité (S_{I}), et **en ce que** le dispositif de compensation (10) présente une bobine de compensation (12) réalisée pour magnétiser en plus en sens inverse la boucle magnétique (2) au moyen de la tension de compensation (U_{K}) générée.

7. Dispositif de mesure de courant selon une des revendications précédentes, **caractérisé en ce que** le dispositif de compensation (10) présente un second détecteur de courant (17) réalisé pour détecter le courant de compensation (I_{K}) circulant dans la bobine de compensation (12).

8. Dispositif de mesure de courant selon une des revendications précédentes, **caractérisé en ce que** le dispositif de calibrage (13) présente en outre :
un dispositif de commande (14) qui enregistre périodiquement à intervalles prédéterminés dans le temps une première intensité (S_{IK}) du courant de compensation (I_{K}) et génère ensuite un signal de commande (S_{St}) pour l'activation ;
une source de courant (15) qui génère un courant défini (I_{Test}) en fonction du signal de commande (Sₛₜ) ;
une bobine de calibrage (16) réaliseé pour magnétiser en plus la boucle magnétique (2) en fonction du courant défini (I_{Test});
le dispositif de commande (14) étant réalisé pour enregistrer une seconde intensité (S_{IK}) du courant de compensation (I_{K}) lorsque la boucle magnétique (2) est magnétisée au moyen du courant défini (I_{Test}) et le dispositif de commande (14) étant réalisé pour définir une intensité calibrée (S_{IKal}) à partir de la différence entre la première intensité enregistrée et la seconde intensité enregistrée.

9. Dispositif de mesure de courant selon une des revendications précédentes, **caractérisé en ce que** le dispositif d'intégration (8) est réalisé sous la forme d'un circuit analogique.

10. Dispositif de mesure de courant selon une des revendications précédentes, **caractérisé en ce que** un circuit intégré, en particulier un système dirigé par un programme, est prévu et présente le dispositif d'intégration (8).

11. Dispositif de mesure de courant selon une des revendications précédentes, **caractérisé en ce que** la boucle magnétique (2) est réalisée sous la forme d'une boucle magnétique (2) sans entrefer.

12. Dispositif de mesure de courant selon une des revendications précédentes, **caractérisé en ce que** la bobine d'excitation (6) est réalisée sous la forme d'une bobine simple ou double.

13. Onduleur solaire, en particulier onduleur solaire sans transformateur, qui comporte
un dispositif de mesure de courant (1) selon une des revendications 1 à 12.

14. Procédé de détection d'un courant (I), en particulier au moyen d'un dispositif de mesure de courant (1) selon une des revendications 1 à 13, qui comporte les étapes consistant à :
magnétiser (S1) une boucle magnétique (2) destinée à recevoir une ligne de courant (L) au moyen d'un signal périodique (U_{E}) au moyen d'un dispositif d'excitation (3) ;
faire passer (S2) une ligne de courant (L) au travers de la boucle magnétique (2) ;
alimenter (S3) la ligne de courant (L) en courant (I) à détecter ;
détecter (S4) un courant d'excitation (I_{E}) qui circule dans le dispositif d'excitation (3) en raison du signal périodique (U_{E}) et/ou du courant (I) ;
enregistrer périodiquement une première intensité (S_{IK}) du courant de compensation (I_{K}), la boucle magnétique (2) n'étant alors pas magnétisée en plus au moyen d'un courant d'essai défini (I_{Test});
activer ensuite une source de courant (15) qui génère le courant de test défini (I_{Test}) ;
magnétiser la boucle magnétique (2) par l'intermédiaire d'une bobine de calibrage (16), au moyen du courant de test défini (I_{Test}) ;
enregistrer une seconde intensité (S_{IK}) du courant de compensation (I_{K}) qui circule dans la bobine de compensation (12), la boucle magnétique (2) étant en plus magnétisée au moyen du courant de test défini (I_{Test});
dériver (S5) une intensité (S_{I}) du courant (I) à détecter à partir du déplacement du courant d'excitation (I_{E}) détecté sur l'axe du courant ;
définir une intensité calibrée (S_{IKal}) au moyen de la différence entre la première intensité et la seconde intensité du courant de compensation (I_{K}) par l'intermédiaire du dispositif de commande (14).

15. Procédé selon la revendication 14, **caractérisé en ce que** la dérivation de l'intensité (S_{I}) présente en outre les étapes suivantes consistant à :
mesurer une première durée (t₊) dans laquelle le courant d'excitation (I_{E}) présente une valeur positive, et une seconde durée (t-) dans laquelle le courant d'excitation (I_{E}) présente une valeur négative ;
intégrer la différence entre la première durée (t₊) et la seconde durée (t-) ; et
définir l'intensité (S_{I}) à partir du résultat d'intégration.
